# EUROPEAN PATENT SPECIFICATION

(11) **EP 1 743 127 B1**
(45) Date of publication and mention of the grant of the patent: **24.08.2016**
(21) Application number: 05738455.4
(22) Date of filing: 05.05.2005
(51) Int. Cl.: F25D 29/00

(54) **SYSTEM AND PROCESS FOR ENERGIZING LOADS THROUGH A CONTROL UNIT**
SYSTEM UND VERFAHREN ZUR SPEISUNG VON LASTEN DURCH EINE STEUEREINHEIT
SYSTEME ET PROCEDE PERMETTANT DE METTRE DE CHARGES SOUS TENSION VIA UNE UNITE DE COMMANDE

(30) Priority: 05.05.2004 BR 0402015
(43) Date of publication of application: 17.01.2007
(73) Proprietor: WHIRLPOOL S.A., 04578-000 São Paulo SP (BR)
(72) Inventor: DUARTE, Ronaldo, Ribeiro, 89218-600 Joinville - SC (BR); SCHWARZ, Marcos, Guilherme, 89204-320 Joinville - SC (BR)
(74) Representative: Patentanwälte Geyer, Fehners & Partner mbB
(86) International application number: PCT/BR2005/000072
(87) International publication number: WO 2005/106359

(56) References cited:
- US-A1- 2004 112 072
- US-B1- 6 655 158

## Description

### Field of the Invention

The present invention refers to a system according to the preamble of claim 1 and a process according to the preamble of claim 10. Such a system and such a process are known from WO 01/37438 A1 and are used to enable the energization and the bidirectional serial communication for controlling the loads provided in electrical household appliances, such as refrigerators, freezers, laundry machines, etc., through a control unit.

### Background of the Art

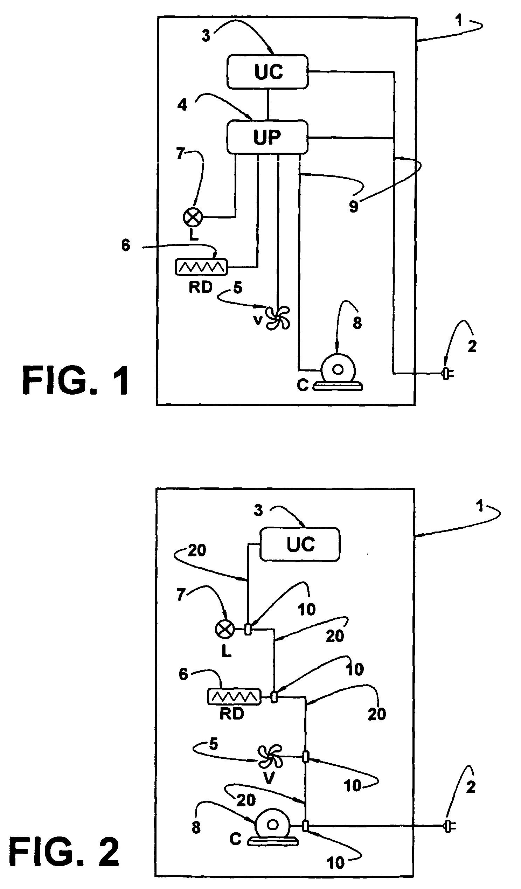

Most electrical household appliances have a large number of electrical loads distributed throughout the system, such as for example lamps, fans, valves, motors, etc., which are essential to the operation of the equipment and typically commanded by a control unit, which supplies or not voltage thereto as a function of the process requirements. The energization control of the loads is effected by semi-conducting electromechanical or triac AC switches, such as the electromagnetic relays, which are typically located in a power unit that receives the voltage from the power network and distributes it to the loads through adequate electrical cables. Figure 1 shows a typical diagram of the electrical connections of a refrigerator 1 operatively connected to a power network 2 and comprises a control unit 3, a power unit 4, a fan 5, a defrost resistance 6, an internal lamp 7 and a compressor 8. As it can be noted, the existence of several loads in the system requires a large number of cables 9 distributed throughout the appliance, increasing the electromagnetic noise, the cost of the wirings and making difficult the mounting process, bearing in mind that the larger the number of loads and wirings the higher the complexity of the system.

In order to reduce the aforesaid problems related to the distribution of loads, the automobile industries have developed serial communication standards, aiming at eliminating the individual cables for each load of the system. Among said standards, CAN standard is the best known. For applications in which the system does not require high speed or high data flow, the so-called LIN standard has been developed. In said applications, the voltage is directly supplied to the load, which has a local power switch and the control unit 2 commands the selective energization of the load through serial communication. In both serial communication standards, the level of the signal used in the communication is different from the level of the voltage of the AC power network. Thus, for applications in household appliances, special circuits for conversion of signals should be used, as well as the installation of two additional conductors exclusively for the serial communication.

A serial communication standard known as X-10 specifies the serial communication directly through the power network by modulating a high frequency signal over the network, which signal is normally used for establishing communication between appliances in a home or to access the Internet, dispensing the installation of telephone or network cables. The great disadvantage of said standard is that it requires a usually complex and relatively expensive filtering circuit for separating the communication signal from the power network.

There is also the industrial communication standard known as AS-i, whose principle is similar to that of the already described X-10, in which supply voltage and communication travel through the same conductors, in different frequency spectra, in which case the supply voltage is in DC, usually of 24Vdc. AS-i standard is widely used in industrial networks for communication with sensors and actuators.

It can be concluded from the basic description of some of the existing communication standards that all of them require complex dedicated electronic circuits to execute the tasks of separating and/or treating the signals, but which become infeasible in systems in which cost is a preponderant factor and which do not require high speed or transmitted data high flow.

Thus, it is an object of the present invention to improve the above mentioned system and the above mentioned process.

The object is solved by the system according to claim 1 and the process according to claim 10.

Further developments of the inventive system and the inventive process are given in the dependent claims.

Thus, there is provided a system for energizing loads through a control unit, for loads provided in electrical household appliances, from a serial communication network, with a simple and strong topology and of reduced cost and which allows reducing the manufacture and assembly costs of said appliances, simplifying the assembly and reducing the steps involved in the manufacture of said electrical appliances and which can be used in large scale in said appliances.

Further the provided system as cited above allows the modularity and expansion of said system.

By providing a system as cited above the use of specific boxes and power units for each project can be dispensed.

The inventive process for energizing loads through the control unit, said loads being located in an electrical appliance, can simplify the assembly of the presently used systems.

The inventive process can be implemented with micro-controllers of low cost.

### Brief Description of the Drawings

The invention will be described below with reference to the enclosed drawings, given by way of example only and in which:
Figure 1 illustrates, schematically, a refrigerator in which the wiring between the control unit, the power network and the several loads therein is constructed according to the prior art;
Figure 2 illustrates, schematically, a refrigerator in which the wiring between the control unit, the power network and the several loads therein is constructed according to the present invention;
Figure 3 illustrates, schematically, an embodiment of a system for energizing loads through a control unit provided with an electronic control, constructed according to the present invention;
Figure 4 illustrates, schematically, another embodiment of the system for energizing loads of the present invention;
Figure 5 illustrates, schematically, a first electronic embodiment for the connecting element of the system for energizing loads of the present invention;
Figure 6 illustrates, schematically, a second electronic embodiment for the connecting element of the system for energizing loads of the present invention; and
Figure 7 illustrates, schematically, an electronic embodiment for the connecting element associated with the control unit of the system for energizing loads of the present invention.

### Detailed Description of the Invention

According to the description above and to the appended drawings, the system for energizing loads through a control unit of the present invention is applied to a refrigeration appliance, such as a refrigerator 1, in which the loads to be energized, as illustrated in figures 1 and 2 and as mentioned above, comprise a control unit 3 operatively connected to a power network 2, a fan 5, a defrost resistance, an internal lamp 7, and a compressor 8.

However, it should be understood that the inventive concept of said system can be applied to any appliance whose loads are to be energized by command of a central control unit.

The system for energizing loads through a control unit of the present invention comprises, as described below, connecting elements 10, each comprising an electronic circuit having a power switch 11 and a processing unit 12 operatively connected to the power switch 11 so as to lead the latter to opening and closing conditions, de-energizing and energizing a respective adjacent load which is electrically coupled to the connecting element 10. For a refrigerator 1, each load can be represented by one of the following components: fan 5, defrost resistance 6, inner lamp 7, and compressor 8.

According to the present invention, each connecting element 10 can be connected to a cable 20 with at least three wires, two of these wires defining a pair of electrical conductors 21 which are connected to the power network 2 and disposed so as to define an energizing means which is common to the connecting elements 10 and to the control unit 3, and the third wire defining a signal conductor 22, not galvanically insulated from the power network 2, related to the bidirectional serial communication and which is common to the processing units 12 and to the control unit 3, connecting them in such a way as to allow the control unit 3 to instruct, through the processing units 12 and through coded electrical signals, the opening and closing of each respective power switch 11.

The pair of electrical conductors 21 and signal conductor 22 of the cable of the present invention is designed to travel through each of a plurality of loads of the appliance provided with the present energizing system, each of said loads being connected to said conductors through a respective connecting element 10, as shown in figure 2. Thus, the several individual cables that usually interconnect the control unit 3 and to the loads such as it occurs in the prior art construction illustrated in figure 1 are eliminated, facilitating the mounting steps of said cables in the assembly lines of the appliances provided with the energizing system of the present invention, since besides the existence of a smaller amount of wires distributed throughout said appliance, the connecting elements 10 of the present invention can be provided with an optimized connecting system which can be rapidly coupled to the cable. The command to switch on and off each of the individual loads is carried out by the control unit 3, which can be located in any part of the system.

The serial communication of the present invention is of the non-simultaneous bidirectional type, i.e., of the half-duplex type, master and slave, in which the control unit 3 is the master and each of the connecting elements 10 is a slave and responds only to the commands sent by the master.

According to the present invention, the signal conductor 22 is disposed along the pair of electrical conductors 21, and the cable 20, which defines an assembly of said conductors, passes through all the connecting elements 10 and the control unit 3.

In a construction of the present invention, the connecting element 10 comprises a body carrying inlet terminals 13, each removably coupling a conductor selected from the pair of electrical conductors 21 and the signal conductor 22, one of the inlet terminals 13 associated to an electrical conductor 21 being operatively connected to the power switch 11; and outlet terminals 14, one of them operatively connected to said power switch 11 and the other directly connected to the other inlet terminal 13, said outlet terminals 14 being removably coupled to a respective load.

The inlet terminals 13 can be for example of the type which is adequate for rapid coupling, such as the one of the perforating type.

Each connecting element 10 further comprises provided inside the respective body, besides the power switch 11 and the processing unit 12, a serial interface 15, which is operatively connected to an energization inlet terminal 13, to a communication inlet terminal 13 and to the processing unit 12, in order to enable at least one of the operations of energization, in low voltage, of the connecting element 10 and of bidirectional serial communication between said processing unit 12 and the_control unit 3.

Each connecting element 10 further comprises a sensor 16 for detecting the zero voltage of the power network 2 and which is associated to the respective processing unit 12, in order to impart synchronism to the communication between the control unit 3 and each processing unit 12 through the signal conductor 22.

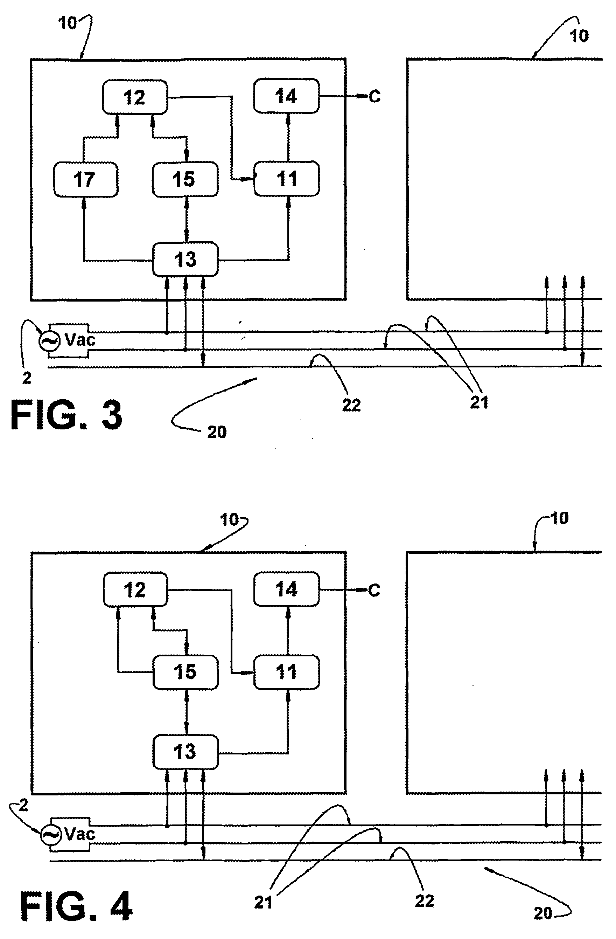

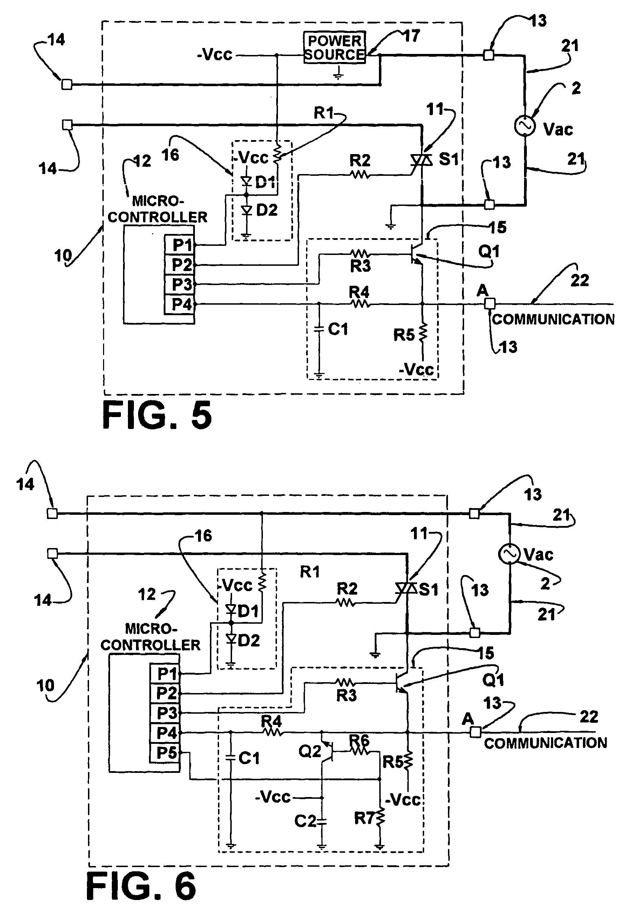

In a particular constructive form illustrated in figures 3 and 5, connecting elements 10 of the slave type, i.e., other than those coupled to the control unit 3, further comprise a power source 17, preferably of the capacitive type since the consumption of the circuit is very low, said power source 17 having an inlet electrically connected to one of the energization inlet terminals 13, and an outlet electrically connected to the internal electronic circuit of the connecting element 10. In this embodiment, the energization of each connecting element 10 occurs through the pair of electrical conductors 21, while the signal conductor 22 operates only the bidirectional transmission of communication signals between the control unit 3 and each connecting element 10. For this construction of connecting element 10 of the slave type, it is not necessary for a connecting element 10 of the master type and associated to the control unit 3 to present the outlet of its power source 17 connected to the serial interface 15.

In the solution illustrated in figures 4 and 6, the connecting elements 10 of the slave type do not have a power source 17. In this embodiment, the energization of each connecting element 10 is made through the signal conductor 22, which has the function of providing the bidirectional serial communication between the control unit 3 and the processing unit 12 of each connecting element 10, as well as the function of energizing the respective connecting element 10, said functions being selective and alternated in time by instruction of the control unit 3 and carried out when the frequency of the power network passes by zero. In this construction, each connecting element 10 of the slave type comprises a serial interface 15 which enables the operation of bidirectional serial communication and which also enables to extract the supply voltage, in a low voltage, from the communication signal conductor 22 to the internal circuit of the respective connecting element 10.

For this construction of connecting element 10 of the slave type, the connecting element 10 coupled to the control unit 3 comprises a power source 17 having an inlet electrically connected to one of the energization inlet terminals 13 and an outlet electrically connected to the serial interface 15, so that the latter enables the operation of bidirectional serial communication with the connecting elements 10 operatively coupled to the loads and the supply of a low voltage, through the communication signal conductor 22, to the connecting elements 10. With this solution, it is possible to reduce the size and cost of the circuit, making even more viable its use in large scale.

Figure 5 illustrates a constructive form of a circuit for a connecting element 10 of the type which presents a power source 17. According to this construction, in a condition in which the circuit is not transmitting data, a first transistor Q1 of the serial interface 15 is in an open state and the communication terminal 13, which is indicated by "A" in said figure 5, is led to a voltage level of -Vcc, through a fifth resistor R5 of the serial interface 15. Transmission of data occurs when the processing unit 12 of the connecting element 10 instructs one of the conditions of closing and opening of the first transistor Q1, from an outlet of the processing unit 12, indicated by P3, leading the voltage level from point A to 0V or -Vcc, according to the bit transmitted. Reading of data is made by a digital inlet P4 of the processing unit 12, as illustrated in figure 5, after said data has passed through a filter formed by a first capacitor C1 and through a fourth resistor R4, preventing the noise from passing to the processing unit 12. The circuit provides low speed asynchronous serial communication, though it allows also the implementation of a synchronous communication, using the voltage of the power network for synchronism, obtained from a first resistor R1 of the sensor 16 and from a first and a second protective diode D1 and D2 of said sensor 16, by applying an input signal P1 of the processing unit 12.

The advantage of the synchronization through the power network 2 is the simplification of the software for the serial communication, since a strict timing control is not required, allowing the use of processing units in the form of micro-controllers of low cost.

Patent EP 0711018A2 discloses a solution in which the synchronization occurs through the power source, but by conventionally using two or more wires for the communication between the loads, said solution requiring however said wires to be galvanically insulated to avoid the passage of current therethrough as a function of installation safety requirements for the application intended by said solution.

Figure 6 presents an electronic diagram of a constructive variant in which the power source 17 is not illustrated. In this construction, the circuit is supplied by the voltage available from the signal conductor 22, which has the function of supplying current to the inner circuit of the connecting element 10, besides serving as means for the bidirectional serial communication.

Differently from the prior art techniques of simultaneous data multiplexing and supply, the solution of the present invention allows dividing the time in the signal conductor 22 between communication and energization of the circuits.

Data transmission occurs, as already described, upon the selective closing and opening of the first transistor Q1, forcing the voltage of the communication line to 0V or to -Vcc as a function of the bit transmitted and, in this interval, a second transistor Q2 of the connecting element 10 illustrated in figure 6 remains open upon application of a voltage -Vcc to an outlet pin P5 of the processing unit 12. In the time interval in which the signal conductor 22 is dedicated to supply energy to the circuits of the connecting elements 10, the processing unit 12 instructs the closing of the second transistor Q2, applying a voltage of 0V to the outlet pin P5 of said processing unit 12, so that a bus capacitor C2 can be loaded, supplying current to the circuit in the subsequent instants when the signal conductor 22 has again the communication function and until the processing unit 12 instructs again the closing of the transistor Q2, interrupting the communication for energizing the respective connecting element 10.

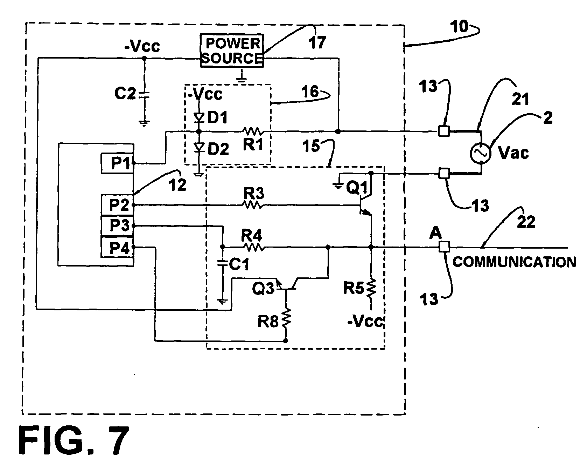

Figure 7 illustrates a constructive form of a circuit suggested for a connecting element of the master type and which is operatively associated with the control unit 3, said connecting element 10 including, besides the components already discussed for the connecting elements 10 of the type associated with the loads, a third transistor Q3, which remains in an open state while an outlet P4 of the processing unit 12 has a - Vcc voltage, allowing the normal data transmission and reception. In the time interval designed to the energization of the circuits, the processing unit 12 instructs the third transistor Q3 to close, applying a voltage of 0V to the outlet pin P4 and allowing the load stored in the second capacitor C2 and generated by the power source 17 to be supplied to the signal conductor 22. Simultaneously, the other connecting elements 10 of the present system associated to loads enable the input of energy to its individual storage capacitors.

The synchronism designed for the communication and energization intervals is effected from the power network 2 so that, for example in positive half-cycles, the signal conductor 22 operates in communication. In this situation, all the connecting elements 10, acting as masters, will command a third transistor Q3 to also remain in an open state. The communication will occur normally, according to the known concepts of master-slave protocols. In the negative half-cycles, no communication will occur, thus all the first communication transistors Q1 will be in the open state and the processing unit 12 of each connecting element 10 will instruct the second transistors Q2 (fig. 6) to enter in the closed state, allowing current to flow therethrough and, simultaneously, the connecting element 10 acting as a master will instruct the third transistor Q3 to close, allowing the stored generated energy to flow toward the connecting elements 10 that are acting as slaves, supplying the latter. Both the connecting elements 10 acting as slaves and the connecting element 10 acting as a master are conducted to synchronism upon the voltage of the electrical network 2 passing by zero.

Since the half-cycle of the electrical network 2 is dedicated to supply energy to the circuits of the connecting elements 10, the remaining time is of 50 half-cycles available for communication in a network of 50Hz, i.e., a transfer rate of 50 bits per second or approximately 5 bytes per second, considering the signaling bits. Since the basic commands are to switch on and switch off, it is possible in a single byte to send the address of the controlled connecting element 10 as well as the full command and, if one byte is considered as a response, two commands per second will be possible. The protocol utilized should include the constant supply of a checking character by the connecting element 10 acting as a master and in case it fails, each of the slave or controlled connecting elements 10 must switch off the respective load for the sake of safety, since an unexpected interruption might have occurred in the communication line.

The implementations described above encompass connecting elements 10 of the controlled type and which activate loads. However, it should be understood that the scope of the present invention could be extended to connecting elements 10 which operatively connect the control unit 3 to at least one sensor which provides signals representative of operational conditions of an appliance provided with said energizing system, so that said connecting elements, such as switches, digital and analogical sensors, thermostats, etc., receive input signals.

## Claims

1. A system for energizing loads provided in electrical household appliances through a control unit, said loads being energized from an AC power network, wherein the system comprises:
- connecting elements (10), each comprising a power switch (11) and a processing unit (12) operatively connected to the power switch (11) so as to lead the latter to opening and closing conditions, de-energizing and energizing a respective adjacent load that is electrically coupled to the connecting element (10)
- a pair of electrical conductors (21) connected to the AC power network (2) and which are disposed so as to define an energizing means which is common to the connecting elements (10) and to the control unit (3);
**characterized in that**
- the AC power network (2) supplying energy to the connecting elements (10) in a half-cycle, the remaining half-cycle of the AC power network (2) being available for communication;
- and said system comprises a signal conductor (22) not galvanically insulated from the AC power network (2) and which is common to the processing units (12) and to the control unit (3), connecting them so as to allow the control unit (3) to instruct, through the processing units (12) and through coded electrical signals, the opening and closing of each respective power switch (11).

2. The system as set forth in claim 1, **characterized in that** each connecting element (10) comprises a sensor (16) for detecting the zero voltage of the power network (2) and which is associated with the respective processing unit (12) so as to impart synchronism to the serial communication between the control unit (3) and each processing unit (12) through the signal conductor (22).

3. The system as set forth in claim 1, **characterized in that** the signal conductor (22) is disposed along the pair of electrical conductors (21) and that they travel together through all connecting elements (10) and through the control unit (3).

4. The system as set forth in claim 1, **characterized in that** the signal conductor (22) operatively connects the control unit (3) to at least one sensor (16) that provides signals representative of the operational conditions of an appliance provided with said energizing system.

5. The system as set forth in claim 1, **characterized in that** each connecting element (10) comprises a body carrying inlet terminals (13), each removably coupling a conductor selected from the pair of electrical conductors (21) and from the signal conductor (22), one of the inlet terminals (13) associated with an electrical conductor (21) being operatively connected to the power switch (11); and outlet terminals (14), one of them being operatively connected to said power switch (11) and the other directly connected to the other inlet terminal (13), said outlet terminals (14) being removably coupled to a respective load.

6. The system as set forth in claim 1, **characterized in that** each connecting element (10) further comprises a serial interface (15) operatively connected to an energization inlet terminal (13), to a communication inlet terminal (13), and to the processing unit (12), in order to allow at least on of the operations of energization, in low voltage, of the connecting element (10) and of bidirectional serial communication between said processing unit (12) and the control unit (3).

7. The system as set forth in claim 6, **characterized in that** a connecting element (10) coupled to the control unit (3) comprises a power source (17) having an inlet electrically connected to one of the energization inlet terminals (13) so that the latter enables the operation of bidirectional serial communication with the connecting elements (10) operatively coupled to the loads and the supply of low voltage, through the communication signal conductor (22), to the connecting elements (10).

8. The system as set forth in claim 6, **characterized in that** the connecting elements (10) operatively coupled to the loads each comprise a serial interface (15) which enables the operation of bidirectional serial communication and extraction of the supply voltage, in a low voltage, from the communication signal conductor (22) to the internal circuit of the respective connecting element (10).

9. The system as set forth in claim 7, **characterized in that** each connecting element (10) operatively associated with a load comprises a power source (17) having an inlet electrically connected to one of the energization inlet terminals (13) and an outlet electrically connected to the internal circuit of the respective connecting element (10).

10. A process for energizing loads provided in electrical household appliances through a control unit, said loads being energized from an AC power network (2), wherein said process comprises the steps of:
a- connecting the AC power network (2) to the control unit (3) by means of a pair of electrical conductors (21) ;
b- connecting, electrically and through a respective power switch (11) of connecting elements (10), each load to said pair of electrical conductors (21);
c- operatively associating, to each power switch (11), a respective processing unit (12) which is designed to lead said respective power switch (11) to opening and closing conditions;
characterized that
the AC power network (2) supplies energy to the connecting elements (10) in a half-cycle, the remaining half-cycle of the AC power network (2) being available for communication; and said process comprises
d- connecting the control unit (3) to the processing units (12) through only one signal conductor (22), not galvanically insulated from the AC power network (2) and which is common to said units, in order to instruct through said processing units (12) the opening and closing conditions of the respective power switches (11), in the remaining half-cycle of the AC power network (2).

11. The process as set forth in claim 10, **characterized in that** in step "d" the instruction for operating the power switches (11) is synchronized with the passage of the power network voltage by zero.

## Patentansprüche

1. System zur Speisung von in elektrischen Haushaltsgeräten vorgesehenen Lasten durch eine Steuereinheit, wobei die Lasten von einem Wechselstromnetz gespeist werden, wobei das System aufweist:
- Verbindungselemente (10), die jeweils einen Netzschalter (11) und eine mit dem Netzschalter (11) wirkverbundene Verarbeitungseinheit (12) aufweisen, so dass der Netzschalter in einen geöffneten Zustand und einen geschlossenen Zustand gebracht wird, wodurch eine entsprechende benachbarte Last, die elektrisch mit dem Verbindungselement (10) gekoppelt ist, abgeschaltet und gespeist wird,
- ein Paar von elektrischen Leitern (21), die mit dem Wechselstromnetzwerk (2) verbunden sind und die so vorgesehen sind, dass sie ein gemeinsames Speisemittel für die Verbindungselemente (10) und die Steuereinheit (3) festlegen,
**dadurch gekennzeichnet, dass**
- das Wechselstromnetzwerk (2) die Verbindungselemente (10) in einem halben Zyklus mit Energie versorgt, der verbleibende halbe Zyklus des Wechselstromnetzwerks (2) zur Kommunikation verfügbar ist,
- und das System einen Signalleiter (22) aufweist, der von dem Wechselstromnetzwerk (2) nicht galvanisch isoliert ist und der sowohl für die Verarbeitungseinheiten (12) als auch für die Steuereinheit (3) vorgesehen ist, sie so verbindet, dass die Steuereinheit (3) das Öffnen und Schließen von jedem entsprechenden Netzschalter (11) durch die Verarbeitungseinheiten (12) und durch kodierte elektrische Signale instruieren kann.

2. System nach Anspruch 1, **dadurch gekennzeichnet, dass** jedes Verbindungselement (10) einen Sensor (16) aufweist, der zur Detektion der Null-Spannung des Stromnetzwerks (2) dient und der der entsprechenden Verarbeitungseinheit (12) zugeordnet ist, so dass Gleichlauf für die serielle Kommunikation zwischen der Steuereinheit (3) und jeder Verarbeitungseinheit (12) durch die Signalleiter (22) vermittelt wird.

3. System nach Anspruch 1, **dadurch gekennzeichnet, dass** der Signalleiter (22) entlang des Paares der elektrischen Leiter (21) angeordnet ist und dass sie zusammen durch alle Verbindungselemente (10) und durch die Steuereinheit (3) verlaufen.

4. System nach Anspruch 1, **dadurch gekennzeichnet, dass** der Signalleiter (22) die Steuereinheit (3) mit zumindest einem Sensor (16), der Signale bereitstellt, die die Betriebsbedingungen eines mit dem Speisesystem vorgesehenen Gerätes repräsentieren, betriebsmäßig verbinden.

5. System nach Anspruch 1, **dadurch gekennzeichnet, dass** jedes Verbindungselement (10) einen Körper aufweist, der Eingangsanschlüsse (13), die jeweils lösbar einen Leiter ausgewählt von dem Paar von den elektrischen Leitern (21) und von dem Signalleiter (22) koppeln, und Ausgangsanschlüsse (14) trägt, wobei einer der Eingangsanschlüsse (13) einem elektrischen Leiter (21) zugewiesen ist, der mit dem Netzschalter (11) wirkverbunden ist, wobei einer der Ausgangsanschlüsse wirkverbunden mit dem Netzschalter (11) und der andere direkt mit dem anderen Eingangsanschluss (13) verbunden ist, wobei die Ausgangsanschlüsse (14) entfernbar mit einer entsprechenden Last gekoppelt sind.

6. System nach Anspruch 1, **dadurch gekennzeichnet, dass** jedes Verbindungselement (10) ferner eine serielle Schnittstelle (15) aufweist, die wirkverbunden ist mit einem Speiseeingangsanschluss (13), einem Kommunikationseingangsanschluss (13) und der Verarbeitungseinheit (12), um zumindest eine der Aktionen des Speisens des Verbindungselementes (10) mit geringer Spannung und der bidirektionalen seriellen Kommunikation zwischen der Verarbeitungseinheit (12) und der Steuereinheit (3) zu ermöglichen.

7. System nach Anspruch 6, **dadurch gekennzeichnet, dass** ein Verbindungselement (10), das mit der Steuereinheit (3) gekoppelt ist, eine Stromquelle (17), die einen Eingang aufweist, der elektrisch mit einem der Speiseeingangsanschlüsse (13) verbunden ist, aufweist, so dass die zuletzt genannte die Aktion der bidirektionalen seriellen Kommunikation mit den Verbindungselementen (10), die wirkgekoppelt sind mit den Lasten und den Verbindungselementen (10) eine geringe Spannung durch den Kommunikationssignalleiter (22) bereitstellen, ermöglicht.

8. System nach Anspruch 6, **dadurch gekennzeichnet, dass** die Verbindungselemente (10), die wirkgekoppelt mit den Lasten sind, jeweils eine serielle Schnittstelle (15) aufweisen, die die Aktion der bidirektionalen seriellen Kommunikation und der Extraktion der Versorgungsspannung in geringer Spannung von dem Kommunikationssignalleiter (22) zur internen Schaltung des entsprechenden Verbindungselementes (10) ermöglicht.

9. System nach Anspruch 7, **dadurch gekennzeichnet, dass** jedes Verbindungselement (10), das wirkmäßig einer Last zugeordnet ist, eine Stromquelle (17) aufweist, die einen Eingang aufweist, der elektrisch mit einem der Speiseeingangsanschlüsse (13) verbunden ist, und einen Ausgang aufweist, der elektrisch mit der internen Schaltung des entsprechenden Verbindungselementes (10) verbunden ist.

10. Verfahren zur Speisung von in elektrischen Haushaltsgeräten vorgesehenen Lasten durch eine Steuereinheit, wobei die Lasten von einem Wechselstromnetzwerk (2) gespeist werden, wobei das Verfahren die Schritte aufweist:
a) Verbinden des Wechselstromnetzwerkes (2) mit der Steuereinheit (3) mittels eines Paares von elektrischen Leitern (21),
b) elektrisches Verbinden und Verbinden durch einen entsprechenden Netzschalter (11) der Verbindungselemente (10) von jeder Last mit dem Paar von elektrischen Leitern (21),
c) wirkmäßiges Zuordnen einer entsprechenden Verarbeitungseinheit (12) zu jedem Netzschalter (11), wobei die entsprechende Verarbeitungseinheit (12) so ausgelegt ist, den entsprechenden Netzschalter (11) in einen geöffneten Zustand und einen geschlossenen Zustand zu bringen,
**dadurch gekennzeichnet, dass**
das Wechselstromnetzwerk (2) Energie an die Verbindungselemente (10) in einem halben Zyklus anlegt, wobei der verbleibende halbe Zyklus des Wechselstromnetzwerkes (2) für eine Kommunikation verfügbar ist, und das Verfahren aufweist
d) Verbinden der Steuereinheit (3) mit den Verarbeitungseinheiten (12) durch nur einen Signalleiter (22), der nicht galvanisch isoliert ist von dem Wechselstromnetzwerk (2) und der gemeinsam für die Einheiten vorgesehen ist, um den geöffneten Zustand und den geschlossenen Zustand der entsprechenden Netzschalter (11) durch die Verarbeitungseinheiten (12) in dem verbleibenden halben Zyklus des Wechselstromnetzwerkes (2) anzuweisen.

11. Verfahren nach Anspruch 10, **dadurch gekennzeichnet, dass** im Schritt d) die Anweisung zum Betrieb der Netzschalter (11) synchronisiert wird mit dem Nulldurchgang der Netzwerkspannung.

## Revendications

1. Système pour exciter des charges fournies dans des appareils électroménagers à travers une unité de commande, lesdites charges étant excitées à partir d'un réseau d'alimentation en courant alternatif, dans lequel le système comprend :
- des éléments de connexion (10), comprenant chacun un interrupteur d'alimentation (11) et une unité de traitement (12) connectée fonctionnellement à l'interrupteur d'alimentation (11), de manière à amener ce dernier à des états d'ouverture et de fermeture, en désexcitant et en excitant une charge adjacente respective qui est couplée électriquement à l'élément de connexion (10) ;
- une paire de conducteurs électriques (21) qui sont connectés au réseau d'alimentation en courant alternatif (2), et qui sont disposés de manière à définir un moyen d'excitation qui est commun aux éléments de connexion (10) et à l'unité de commande (3) ;
**caractérisé en ce que** :
- le réseau d'alimentation en courant alternatif (2) fournit de l'énergie aux éléments de connexion (10) au cours d'un demi-cycle, le demi-cycle restant du réseau d'alimentation en courant alternatif (2) étant disponible à des fins de communication ; et
- ledit système comprend un conducteur de signal (22), non galvaniquement isolé du réseau d'alimentation en courant alternatif (2), et qui est commun aux unités de traitement (12) et à l'unité de commande (3), et qui les connecte de façon à permettre à l'unité de commande (3) de commander, par l'intermédiaire des unités de traitement (12) et de signaux électriques codés, l'ouverture et la fermeture de chaque interrupteur d'alimentation respectif (11).

2. Système selon la revendication 1, **caractérisé en ce que** chaque élément de connexion (10) comprend un capteur (16) pour détecter la tension nulle du réseau d'alimentation (2) et qui est associé à l'unité de traitement respective (12) de manière à synchroniser la communication série entre l'unité de commande (3) et chaque unité de traitement (12) à travers le conducteur de signal (22).

3. Système selon la revendication 1, **caractérisé en ce que** le conducteur de signal (22) est disposé le long de la paire de conducteurs électriques (21) et **en ce qu'**ils se déplacent ensemble à travers tous les éléments de connexion (10) et à travers l'unité de commande (3).

4. Système selon la revendication 1, **caractérisé en ce que** le conducteur de signal (22) connecte fonctionnellement l'unité de commande (3) à au moins un capteur (16) qui fournit des signaux représentatifs des états de fonctionnement d'un appareil doté dudit système d'excitation.

5. Système selon la revendication 1, **caractérisé en ce que** chaque élément de connexion (10) comprend un corps supportant des bornes d'entrée (13), chacune couplant de manière amovible un conducteur sélectionné parmi la paire de conducteurs électriques (21) et le conducteur de signal (22), l'une des bornes d'entrée (13) étant associée à un conducteur électrique (21) fonctionnellement connecté à l'interrupteur d'alimentation (11) ; et des bornes de sortie (14), dont l'une est connectée fonctionnellement audit interrupteur d'alimentation (11) et l'autre est directement connectée à l'autre borne d'entrée (13), lesdites bornes de sortie (14) étant couplées de manière amovible à une charge respective.

6. Système selon la revendication 1, **caractérisé en ce que** chaque élément de connexion (10) comprend en outre une interface série (15) connectée fonctionnellement à une borne d'entrée d'excitation (13), à une borne d'entrée de communication (13), et à l'unité de traitement (12), afin de permettre au moins l'une des opérations d'excitation, à basse tension, de l'élément de connexion (10), et de communication série bidirectionnelle entre ladite unité de traitement (12) et l'unité de commande (3).

7. Système selon la revendication 6, **caractérisé en ce qu'**un élément de connexion (10) couplé à l'unité de commande (3) comprend une source d'alimentation (17) présentant une entrée connectée électriquement à l'une des bornes d'entrée d'excitation (13), de sorte que celle-ci permet l'opération de communication série bidirectionnelle avec les éléments de connexion (10) couplés fonctionnellement aux charges et la fourniture d'une basse tension, par l'intermédiaire du conducteur de signal de communication (22), aux éléments de connexion (10).

8. Système selon la revendication 6, **caractérisé en ce que** les éléments de connexion (10) couplés fonctionnellement aux charges comprennent chacun une interface série (15) qui permet l'opération de communication série bidirectionnelle et l'extraction de la tension d'alimentation, à basse tension, du conducteur de signal de communication (22) au circuit interne de l'élément de connexion respectif (10).

9. Système selon la revendication 7, **caractérisé en ce que** chaque élément de connexion (10) associé fonctionnellement à une charge comprend une source d'alimentation (17) présentant une entrée connectée électriquement à l'une des bornes d'entrée d'excitation (13) et une sortie connectée électriquement au circuit interne de l'élément de connexion respectif (10).

10. Procédé d'excitation de charges fournies dans des appareils électroménagers à travers une unité de commande, lesdites charges étant excitées à partir d'un réseau d'alimentation en courant alternatif (2), dans lequel ledit procédé comprend les étapes ci-dessous consistant à :
a- connecter le réseau d'alimentation en courant alternatif (2) à l'unité de commande (3) au moyen d'une paire de conducteurs électriques (21) ;
b- connecter, électriquement et par le biais d'un interrupteur d'alimentation respectif (11) d'éléments de connexion (10), chaque charge à ladite paire de conducteurs électriques (21) ;
c- associer fonctionnellement, à chaque interrupteur d'alimentation (11), une unité de traitement respective (12) qui est conçue pour amener ledit interrupteur d'alimentation respectif (11) à des états d'ouverture et de fermeture ;
**caractérisé en ce que** :
le réseau d'alimentation en courant alternatif (2) fournit de l'énergie aux éléments de connexion (10) au cours d'un demi-cycle, le demi-cycle restant du réseau d'alimentation en courant alternatif (2) étant disponible à des fins de communication ; et **en ce que** ledit procédé comprend l'étape ci-dessous consistant à :
d- connecter l'unité de commande (3) aux unités de traitement (12) à travers un unique conducteur de signal (22), non isolé galvaniquement du réseau d'alimentation en courant alternatif (2) et qui est commun auxdites unités, afin de commander, par l'intermédiaire desdites unités de traitement (12), les états d'ouverture et de fermeture des interrupteurs d'alimentation respectifs (11), au cours du demi-cycle restant du réseau d'alimentation en courant alternatif (2).

11. Procédé selon la revendication 10, **caractérisé en ce que**, à l'étape « d », l'instruction d'exploitation des interrupteurs d'alimentation (11) est synchronisée avec le passage à zéro de la tension de réseau d'alimentation.
